(19) Europäisches Patentamt / European Patent Office / Office européen des brevets

(11) **EP 1 330 867 B1**

(12) **EUROPÄISCHE PATENTSCHRIFT**

(45) Veröffentlichungstag und Bekanntmachung des Hinweises auf die Patenterteilung:
**20.11.2013 Patentblatt 2013/47**

(21) Anmeldenummer: **01982185.9**

(22) Anmeldetag: **31.10.2001**

(51) Int Cl.:
*H02N 1/00* (2006.01)   *B81B 3/00* (2006.01)

(86) Internationale Anmeldenummer:
**PCT/DK2001/000719**

(87) Internationale Veröffentlichungsnummer:
**WO 2002/037660 (10.05.2002 Gazette 2002/19)**

(54) **BETÄTIGUNGSELEMENT UND VERFAHREN ZU SEINER HERSTELLUNG**

ACTUATING MEMBER AND METHOD FOR PRODUCING THE SAME

ELEMENT D'ACTIONNEMENT ET SON PROCEDE DE FABRICATION

(84) Benannte Vertragsstaaten:
**AT BE CH CY DE DK ES FI FR GB GR IE IT LI LU MC NL PT SE TR**

(30) Priorität: **02.11.2000 DE 10054247**

(43) Veröffentlichungstag der Anmeldung:
**30.07.2003 Patentblatt 2003/31**

(73) Patentinhaber: **Danfoss A/S**
**6430 Nordborg (DK)**

(72) Erfinder:
• **GRAVESEN, Peter**
**DK-6430 Nordborg (DK)**
• **BENSLIMANE, Mohamed, Yahia**
**DK-6430 Nordborg (DK)**

(74) Vertreter: **Knoblauch, Andreas**
**Patentanwälte Dr. Knoblauch**
**Schlosserstrasse 23**
**60322 Frankfurt am Main (DE)**

(56) Entgegenhaltungen:
WO-A1-96/34701    WO-A1-96/34701
WO-A2-01/06579    JP-A- H01 273 372
US-A- 5 977 685   US-A- 5 977 685

**EP 1 330 867 B1**

**Beschreibung**

Die Erfindung betrifft ein Betätigungselement mit einem Körper aus einem Elastomermaterial mit einer Dicke, einer Längsrichtung und einer Querrichtung, der auf zwei einander gegenüberliegenden Begrenzungsflächen mit jeweils einer Elektrodenanordnung versehen ist.

Ein derartiges Betätigungselement ist aus US 5 977 685 bekannt.

Ferner betrifft die Erfindung ein Verfahren zum Herstellen eines Betätigungselements mit einem Körper aus einem Elastomermaterial, der auf zwei einander gegenüberliegenden Seiten mit Elektroden versehen wird.

Ein weiteres Betätigungselement ist aus der nachveröffentlichten WO 01/06579 A2 bekannt. Hier weist eine Begrenzungsfläche einen gewellten Bereich mit parallel zur Querrichtung verlaufenden Höhen und Tiefen als Extreme auf, der von einer in Querrichtung durchgehenden Elektrode bedeckt ist, die zumindest einen Teil der Extreme vollflächig abdeckt und im Übrigen über den gewellten Bereich zusammenhängt. Der gewellte Bereich wird dadurch erzeugt, dass man einen Polymerfilm stärker dehnt, als dies bei der geplanten Betätigung möglich ist. In diesem gedehnten Zustand wird die Elektrode aufgetragen. Danach wird der Polymerfilm entspannt und zieht sich zusammen. Die aufgetragene Elektrode kann sich jedoch nicht zusammenziehen, sondern bildet Wellen. Eine andere Möglichkeit zur Ausbildung der Wellen besteht in einem reaktiven Ionenätzen.

JP 01273372 zeigt ein Dünnfilm-Piezoelement mit einer gezackten Oberfläche und einer dieser gegenüberliegenden flachen Oberfläche, die mit Kontaktelektroden versehen sind. Die gezackte Oberfläche wird dadurch hergestellt, dass das Piezomaterial in gelöster Form auf eine Schablone aufgetragen wird, die ebenfalls eine gezackte Oberfläche aufweist. Zum Lösen des Piezomaterials wird eine Spannung zwischen der von der Schablone abgewandten flachen Oberfläche des Piezoelements und der Schablone angelegt. Anschließend werden die Oberfächen mit den Kontaktelektroden versehen.

Derartige Betätigungselemente werden auch kurz als "künstliche Muskeln" bezeichnet, weil ihr Verhalten unter gewissen Bedingungen dem von menschlichen Muskeln entspricht.

Die Funktionsweise ist relativ einfach. Wenn eine Spannungsdifferenz an die beiden Elektrode angelegt wird, entsteht ein elektrisches Feld durch den Körper hindurch, wobei das elektrische Feld mechanische Anziehungskräfte zwischen den Elektroden erzeugt. Dies führt zu einer Annäherung der beiden Elektrodenanordnungen und damit verbunden zu einer Kompression des Körpers. Die Annäherung kann noch unterstützt werden, wenn das Material des Körpers dielektrische Eigenschaften hat. Da das Material aber ein im wesentlichen konstantes Volumen hat, führt das Zusammendrücken, also das Vermindern der Dicke, zu einer Vergrößerung der Abmessungen des Körpers in den anderen beiden Richtungen, d.h. parallel zu den Elektroden.

Wenn man nun die Dehnbarkeit des Körpers auf eine Richtung beschränkt, dann wird die Dickenänderung vollständig in eine Längenänderung in die andere Richtung umgesetzt. Für die nachfolgende Erläuterung wird die Richtung, in der die Längenveränderung erfolgen soll, als "Längsrichtung" bezeichnet. Die Richtung, in der eine Längenänderung nicht erfolgen soll, wird als "Querrichtung" bezeichnet. Im bekannten Fall weist die Elektrode eine leitende Schicht mit einer relativ niedrigen Leitfähigkeit auf, auf die in Querrichtung verlaufende Streifen aus einem nicht nachgiebigen Material aufgetragen sind, wobei die Streifen in Längsrichtung einen Abstand zueinander aufweisen. Die leitfähige Schicht soll für eine möglichst gleichförmige Verteilung des elektrischen Feldes sorgen, während die Streifen, vorzugsweise aus einem Metall, die Ausbreitung des Körpers in Querrichtung verhindern sollen. Allerdings ergibt sich hierbei aufgrund der schlechten Leitfähigkeit der elektrisch leitenden Schicht eine gewisse Begrenzung bei der Dynamik.

Der Erfindung liegt die Aufgabe zugrunde, die mechanische Dehnbarkeit eines Betätigungselements zu verbessern.

Diese Aufgabe wird durch ein Betätigungselement mit den Merkmalen des Anspruchs 1 gelöst.

Mit dieser Ausgestaltung erreicht man mehrere Vorteile: Da die Elektrode in Querrichtung durchgehend ausgebildet ist, begrenzt sie die Dehnbarkeit des Körpers in diese Querrichtung. "Durchgehend" soll hierbei bedeuten, dass die Elektrode eine Form hat, die nicht noch gestreckt werden kann, beispielsweise eine gerade Linie. Die gesamte Verformung, die sich bei einer Verringerung der Dicke des Körpers ergibt, wird in eine Änderung der Ausdehnung in Längsrichtung umgesetzt. Natürlich wird sich in der Praxis aufgrund von realen Materialien auch eine kleine Änderung in Querrichtung ergeben. Diese ist jedoch verglichen mit der Änderung der Ausdehnung in Längsrichtung vernachlässigbar. Da sich die Elektrode zusammenhängend über den gesamten gewellten Bereich erstreckt, wird sichergestellt, dass die elektrische Leitfähigkeit der Elektrode groß genug ist, so dass der Aufbau des elektrischen Feldes, das zur Verringerung der Dicke des Körpers erforderlich ist, schnell erfolgen kann. Man kann daher mit dem Betätigungselement durchaus hohe Frequenzen realisieren. Da die Oberfläche des Körpers zumindest in einem vorgegebenen Bereich gewellt ist und die Wellung parallel zur

Querrichtung verläuft, steht in Längsrichtung eine Oberfläche zur Verfügung, die zumindest im Ruhezustand des Betätigungselements wesentlich größer als die Längserstreckung des Betätigungselements ist. Wenn man daher die Längserstreckung des Betätigungselements vergrößert, dann wird lediglich die Wellung abgeflacht, d.h. der Unterschied zwischen den Extremen, mit anderen Worten den Spitzen der Höhen und den Tälern der Tiefen, werden kleiner.

Einer Elektrode, die auf diese Oberfläche aufgebracht ist, kann dementsprechend einer Strekkung problemlos folgen, ohne daß die Gefahr besteht, daß die Elektrode von der Oberfläche abgelöst wird. Durch die gewellte Oberfläche erzielt man also eine hervorragende Steifigkeit in der Querrichtung, eine gute Nachgiebigkeit in der Längsrichtung und eine einfach zu realisierende Möglichkeit, die elektrische Spannungsversorgung zum Aufbau des elektrischen Feldes gleichmäßig über die gesamte Oberfläche des Körpers verteilen zu lassen. Der Ausdruck "gewellt" muß nicht heißen, daß es sich hier um bogenförmige oder sinusförmige Konturen handelt. Im Grunde genommen ist hierbei jede Struktur denkbar und zulässig, bei der sich "Berge" mit "Tälern" abwechseln, wobei sich die Berge und die Täler in Querrichtung erstrecken, d.h. in eine Richtung, die unter einem rechten Winkel zur Ausdehnungsrichtung verläuft. Im Querschnitt kann es sich also um eine Sinuswelle, eine Dreieckswelle, eine Sägezahnwelle, eine Trapezwelle oder eine Rechteckwelle handeln. Die Dehnbarkeit wird verbessert, ohne die Dynamik des Betätigungselements zu beeinträchtigen.

Vorzugsweise deckt die Elektrode den gewellten Bereich vollflächig ab. Man verwendet also eine Flächenelektrode, so daß sich die elektrischen Ladungen an jeden Punkt der Begrenzungsfläche des Körpers begeben können, so daß der Aufbau des elektrischen Feldes vergleichmäßigt wird. Gleichzeitig läßt sich die Steifigkeit in Querrichtung weiter verbessern, weil nicht nur die Extreme, also die Kuppen der Berge und die Sohlen der Täler, mit der durchgehenden Elektrode abgedeckt sind, sondern auch die Flanken zwischen den Bergen und Tälern. An der Beweglichkeit in Längsrichtung ändert sich allerdings nichts. Wenn sich der Körper in Längsrichtung ausdehnt, dann werden die Konturen flacher, ohne daß sich zwischen der Zuordnung der Elektrode und dem Körper etwas ändern muß.

Hierbei ist besonders bevorzugt, daß die Elektrode unmittelbar mit dem Körper verbunden ist. Eine zusätzliche leitfähige Schicht ist ohnehin nicht erforderlich, weil die Elektrode die elektrische Leitung für die gesamte Begrenzungsfläche übernimmt. Wenn die Elektrode unmittelbar mit dem Körper verbunden ist, ist die Einflußnahme der Elektrode auf den Körper besser, was sich insbesondere in einer verbesserten Steifigkeit oder Nicht-Dehnbarkeit in Querrichtung äußert.

Vorzugsweise weisen die Extreme Amplituden auf, die nicht größer sind als 20% der Dicke des Körpers zwischen den Begrenzungsflächen. Mit dieser Bemessungsangabe erreicht man eine gleichförmige Verteilung des elektrischen Feldes über die Länge des Betätigungselements, d.h. die Kräfte wirken gleichmäßig auf den Körper, ohne daß sie sich in besonders ausgeprägten Streifen konzentrieren. Unter Amplitude wird hierbei die Hälfte des Unterschieds zwischen benachbarten Extremen verstanden, d.h. die Hälfte des Abstandes zwischen einer Höhe und einer Tiefe.

Vorzugsweise weist die Elektrode eine Stärke auf, die maximal 10% der Amplitude beträgt. Der Dehnbarkeitsfaktor (Compliance factor) Q eines Betätigungselements ist direkt proportional zum Verhältnis zwischen Amplitude und Stärke der Elektrode. Je größer dieses Verhältnis ist, desto größer ist der Dehnbarkeitsfaktor.

Vorzugsweise liegt das Verhältnis zwischen Amplitude und Periodenlänge im Bereich von 0,08 bis 0,25. Das Verhältnis zwischen Amplitude und Periodenlänge hat eine Auswirkung auf die Länge der Oberfläche einer Periode. Je größer die Länge der Oberfläche ist, desto größer ist im Grunde die Dehnbarkeit. Theoretisch könnte man den Körper dehnen, bis die Oberfläche glatt ist, ohne daß die Elektrode dieser Oberfläche darunter leitet. In der Praxis wird die Dehnbarkeit natürlich noch durch andere Parameter begrenzt.

Vorzugsweise weist der gewellte Bereich ein Rechteckprofil auf. Man hat beobachtet, daß sich ein Rechteckprofil am besten in Längsrichtung dehnen läßt. Man führt dies darauf zurück, daß die Elektrode der Oberfläche eine gewisse Steifigkeit auch in Längsrichtung verleiht. Beispielsweise kann man sich bei einem Rechteck vorstellen, dass die parallel zur Längserstreckung liegenden Teile des Rechteckprofils auf den Höhen und in den Tiefen selbst nicht gedehnt werden können. Die Dehnung des Körpers findet also praktisch ausschließlich über die Vergrößerung der Neigung der Flanken und die damit verbundene Verringerung der Amplitude statt.

Vorzugsweise weist das Rechteckprofil Zähne und Zahnlücken auf, die in Längsrichtung gleich lang sind. Dies ermöglicht, dass sich das elektrische Feld möglichst gleichmäßig ausbildet. Gleichzeitig erleichtert diese Gestaltung die Fertigung.

Die Aufgabe wird durch ein Verfahren mit den Merkmalen des Anspruchs 9 gelöst.

Eine derartige Herstellung ist relativ einfach. Eine Elektrodenbearbeitung kann im Grunde entfallen. Es ist lediglich erforderlich, die gewünschte Oberflächenstruktur zu erzeugen. Eine derartige Oberflächenstruktur wird durch das Formpressen erzeugt. Hierzu ist es lediglich erforderlich, Formen mit entsprechenden Strukturen bereit zu stellen. Derartige Formen lassen sich durch bekannte photolithographische Prozesse erzielen, wie sie beispielsweise von der Herstellung von Kompaktdiscs (CD's) bekannt ist.

Hierbei ist besonders bevorzugt, daß die leitende Schicht aufgedampft wird. Eine aufgedampfte Schicht läßt sich mit der gewünschten kleinen Dicke realisieren. Man kann darüber hinaus sicher stellen, daß der Dampf auch in enge Täler eindringen und dort eine Elektrode bilden kann.

Die Erfindung wird im folgenden anhand eines bevorzugten Ausführungsbeispiels in Verbindung mit der Zeichnung näher beschrieben. Hierin zeigen:

Fig. 1    eine schematische Ansicht mit verschiedenen Verfahrensschritten zum Herstellen eines Betätigungselements,

Fig. 2    eine Schnittansicht durch eine Periode,

Fig. 3    eine Kurve zur Verdeutlichung von Verhältnissen bei einem Sinusprofil und

Fig. 4    die gleiche Kurve zur Verdeutlichung von Verhältnissen bei einem Rechteckprofil.

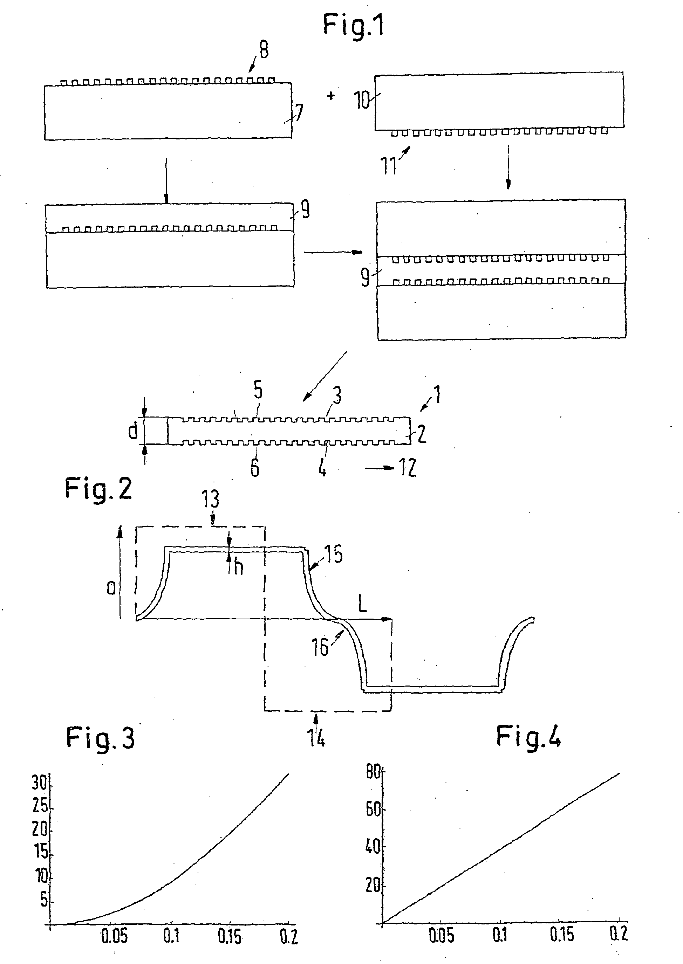

Fig. 1 zeigt verschiedene Schritte zum Herstellen eines Betätigungselements 1 mit einem Körper 2, der zwei Begrenzungsflächen 3, 4 aufweist, die einander gegenüberliegen. Auf beiden Begrenzungsflächen 3, 4 ist jeweils eine Elektrode 5, 6 angebracht. Die Elektrode 5, 6 ist  unmittelbar mit dem Körper 2 verbunden. Der Körper ist aus einem Elastomermaterial, beispielsweise einem Silikonelastomer, gebildet und hat vorzugsweise dielektrische Eigenschaften. Das Material des Körpers 2 ist zwar verformbar. Es weist aber eine Volumenkonstanz auf, d.h. wenn man es in Richtung der Dicke d des Körpers 2 zusammendrückt, dann erfolgt eine Vergrößerung der Ausdehnung des Körpers 2 in die beiden anderen Richtungen. Wenn man nun die Ausdehnung des Körpers 2 in eine Richtung begrenzt, dann führt eine Verminderung der Dicke d ausschließlich zu einer Vergrößerung der Ausdehnung des Körpers 2 in die andere Richtung. Bei dem Ausführungsbeispiel der Fig. 1 soll die Ausdehnungsmöglichkeit senkrecht zur Zeichenebene (Querrichtung) beschränkt sein oder sogar ganz unterbunden werden können. In der Richtung von links nach rechts (bezogen auf Fig. 1), d. h. der Längsrichtung soll hingegen eine Ausdehnung möglich sein. Dieses anisotrope Verhalten wird dadurch erreicht, daß die beiden Begrenzungsflächen 3, 4 des Körpers 2 eine gewellte Struktur aufweisen. In Fig. 1 ist diese gewellte Struktur als Rechteckprofil dargestellt. Es ist aber auch möglich, daß die gewellte Struktur durch ein Sinusprofil, ein Dreiecksprofil, ein Sägezahnprofil oder ein Trapezprofil gebildet wird.

Es liegt ohne weiteres auf der Hand, daß eine undehnbare Elektrode 5, 6, die unmittelbar und damit fest mit dem Körper 2 verbunden ist, eine Ausdehnung des Körpers 2 senkrecht zur Zeichenebene verhindert, wenn der Körper 2 in Richtung seiner Dicke d zusammengedrückt wird. Eine Ausdehnung senkrecht zur Zeichenebene würde voraussetzen, daß auch die Elektroden 5, 6 in diese Richtung dehnbar sind, was definitionsgemäß nicht der Fall ist. Das Zusammendrücken des Körpers erfolgt dadurch, daß die Elektroden 5, 6 mit einer Spannungsdifferenz beaufschlagt werden, so daß sich ein elektrisches Feld zwischen den beiden Elektroden 5, 6 ausbildet, das wiederum Kräfte ausübt, die dazu führen, daß die beiden Elektroden 5, 6 aneinander angezogen werden. Mit eine Voraussetzung hierbei ist, daß der Körper 2 nicht zu dick ist. Vorzugsweise bewegt sich die Dicke d des Körpers 2 im Bereich von wenigen bis einigen 10 $\mu$m.

Die untenstehende Tabelle zeigt typische Werte für Elektrodenschichten und Elastomere sowie typische Werte der Aktivierungsspannung eines Betätigungselements.

| Elastomer Dielektische Konstante | ElastomerDicke | Elastomer ElastizitätsModul | Elektroden-Dicke | Elektrode Elastizitäts-Modul | ElektrodenFläche | ElektrodenWiderstand | Aktivierungsspannung |
|---|---|---|---|---|---|---|---|
| [-] | [um] | [MPa] | [Å] | [GPa] | [cm$^2$] | KOhm] | [V] |
| 2 - 6 | 10-100 | 0,3 - 10 | 100 - 5000 | 1 - 80 | 1-10000 | 0,05-1000 | 100 - 5000 |

Im folgenden betrachten wir einen 20 $\mu$m dicken Silikon-Elastomerfilm mit einem Elastizitätsmodul von 0,7 MPa und einer Dielektrizitäts-Konstante von 3. Die Elektroden sind aus Gold und haben eine Dicke von 0,05 $\mu$m sowie einen Elastizitätsmodul von 80000 MPa. Die Kapazität eines solchen Betätigungselements beträgt 0,1 nF/cm$^2$, und die Sprungantwort liegt in der Größenordnung von Mikrosekunden für das nichtbelastete Betätigungselement. Wenn man einen Dehnbarkeitsfaktor der Elektrode von 4000 annimmt, sind 1000 V nötig, um eine Verlängerung in der Größenordnung von 10% zu erzeugen, wogegen eine Verlängerung von weniger als 0,05 % im Falle einer undehbaren Elektrode erzeugt wird, d.h. einer Elektrode mit einem Dehnbarkeitsfaktor von 1. Mit anderen Worten macht es die Erfindung möglich, die Aktivierungsspannung zu senken.

Das Herstellen eines derartigen Körpers 2 ist relativ einfach. Eine Form 7 mit einer entsprechenden negativen gewellten Struktur, hier eine Rechteckstruktur, wird mit einer Elastomerlösung beschichtet, um einen dünnen Film von typischer Weise 20 bis 30 $\mu$m Dicke zu bilden. Der Film 9 wird dann für eine kurze Zeit gehärtet, so daß er eine relativ weiche Schicht bildet, die immer noch geformt werden kann. Daraufhin wird eine zweite Form 10 mit einer entsprechenden Oberflächenstruktur 11 auf die andere Seite des elastomeren Films 9 gepreßt, wobei beide Pressvorgänge unter Vakuum erfolgen, um das Einschließen von Luft an den Berührungsflächen zwischen Form und Film zu verhindern. Die gesamte Sandwichanordnung aus Film 9 und Formen 7, 10 wird dann komplett ausgehärtet. Wenn die Formen 7, 10 mechanisch entfernt werden, hat der Film 9 die dargestellten gewellten Begrenzungsflächen 3, 4. Abschließend kann praktisch jede leitfähige Schicht auf die gewellten Begrenzungsflächen 3, 4 aufgetragen werden. Beispielsweise kann eine Metallschicht aus Gold, Silber oder Kupfer aufgedampft werden.

Die Auswirkung der gewellten Oberflächenstruktur ergibt sich aus der schematischen Darstellung der Fig. 2. Mit gestrichelten Linien dargestellt ist ein Rechteckprofil in der Ruhestellung, d.h. ohne Anlegen einer elektrischen Spannung an die Elektroden 5, 6. Das Rechteckprofil weist eine Amplitude a und eine Periodenlänge L auf. Die Stärke der leitfähigen Schicht 5 beträgt h. Als Amplitude wird hierbei die Hälfte des Unterschieds zwischen einer Höhe 13 und einer Tiefe 14 angesehen, die man auch als "Berg" und "Tal" bezeichnen kann. Zusammengefaßt werden beide Begriffe als "Extreme" bezeichnet. Wie aus Fig. 1 und 2 zu erkennen ist, haben die Höhe 13 und die Tiefe 14 in Längsrichtung 12 die gleiche Ausdehnung. Die Längsrichtung 12 verläuft in der Fig. 2 von links nach rechts.

Mit durchgezogenen Linien dargestellt ist die Form des Rechteckprofils, wenn sich der Körper in Längsrichtung 12 vergrößert hat. Da das Material des Körpers 2 ein konstantes Volumen besitzt, bedeutet eine Ausdehnung in Längsrichtung 12 gleichzeitig, daß sich das Profil in Dickenrichtung abflacht, wobei die Dickenverminderung zur Verdeutlichung übertrieben groß dargestellt ist. Dieses Profil ist nun mit durchgezogenen Linien dargestellt.

Es ist zu erkennen, daß sich das Profil im Bereich der Höhe 13 und der Tiefe 14 praktisch nicht verlängert hat. Eine Verlängerung des Körpers 2 ist daher nur an den Flanken 15, 16 möglich und zwar ohne, daß sich die Elektroden, die dort befestigt sind, irgendwie dehnen müssen.

Man kann nun verschiedene Relationen festlegen, die besonders vorteilhafte Eigenschaften aufweisen.

So bestimmt das Verhältnis zwischen der Amplitude a des Profils und der Dicke h der leitenden Beschichtung, die die Elektrode 5, 6 bildet, die Dehnbarkeit der gewellten Elektrode und damit die Ausdehnbarkeit des Körpers 2. Für gewellte Profile ist ein Dehnbarkeitsfaktor Q direkt proportional zu dem Quadrat dieses Verhältnisses. Durch die Optimierung dieses Verhältnisses ist es theoretisch möglich, die Dehnbarkeit um einen Faktor 10.000 und darüber hinaus zu steigern. Wenn man beispielsweise eine Beschichtungsdicke von 0,02 $\mu$m und eine Amplitude von 2 $\mu$m hat, ist das Verhältnis 100 und der Dehnbarkeitsfaktor ist 10.000.

Für ein Rechteckprofil, wie es in Fig. 2 dargestellt ist, läßt sich der Dehnbarkeitsfaktor Q leicht aus der Biegestabtheorie berechnen.

$$Q = 16\frac{a}{L}\left(\frac{a}{h}\right)^2 = 16\, v \left(\frac{a}{h}\right)^2, worin\ \ v\ =\ \frac{a}{L}\ ist.$$

Für sinus- oder dreieckförmige Profile gilt im Grunde das gleiche, wobei der konstante Faktor (16 für das Rechteckprofil) für die Sinus- oder Dreieckprofile kleiner ist. Weiterhin muß man das Verhältnis zwischen der Gesamtlänge s einer Periode des Profiles und der Länge L der Periode selbst in Betracht ziehen. Die Länge s ergibt sich, wenn man das Profil "gerade zieht". Im Fall eines Rechteckprofils ergibt sich die Länge s = L + 4a. Wenn das Verhältnis s/L dicht an 1 ist, dann wird sich das Betätigungselement nicht sehr stark bewegen, selbst wenn die Elektrode sehr nachgiebig ist.

In den Fig. 3 und 4 sind nach rechts das Verhältnis zwischen der Amplitude a und der Periodenlänge L und nach oben das Verhältnis 100% x (s-L)/L aufgetragen und zwar in Fig. 3 für ein Sinusprofil und in Fig. 4 für ein Rechteckprofil. In der Praxis benötigt man eine maximale Verlängerung von 20% bis 50%, damit sich ein "künstlicher Muskel" um 10% bis 25% bewegt. Das bedeutet, daß sich das Verhältnis v = a/L im Bereich von 0,1 bis 0,2 bewegen sollte, wenn man ein Rechteckprofil verwendet.

Theoretisch könnte man mit einem Sinusprofil eine Verlängerung von ca. 32% und mit einem Rechteckprofil von ungefähr 80% erreichen. In der Praxis wird dies allerdings nicht der Fall sein, weil beispielsweise das Rechteckprofil aus vertikalen und horizontalen Abschnitten besteht, wobei lediglich erstere zur Nachgiebigkeit oder Dehnbarkeit beitragen. Die horizontalen Abschnitte der Elektrode selbst werden nicht gedehnt.

In einem praktischen Ausführungsbeispiel stellt man eine Form 7 mit Hilfe von Photolithopraphie her, indem man einen positiven Photoresist belichtet und entwickelt. In diesem Fall ist die zum Belichten verwendete Maske relativ einfach. Sie besteht aus parallelen Rechtecken mit einer Breite von 5 $\mu$m und einer Länge, die durch die Größe des Substrats bestimmt ist. Die Rechtecke sind gleichförmig um 5 $\mu$m beabstandet und werden in Ausdehnungsrichtung vervielfacht. Die Höhe des Profils, d.h. die Amplitude, wird definiert als die Hälfte der Dicke der Photoresistschicht, die auf dem Substrat niedergeschlagen wird. Auch diese Höhe kann zu ungefähr 5 $\mu$m gewählt werden.

Für ein gleichförmiges elektrisches Feld ist es allerdings vorteilhaft, wenn die Amplitude mindestens 10 mal kleiner ist, als die Dicke d des Körpers 2. Für einen Elastomerfilm mit einer Dicke von 20 $\mu$m wählt man zweckmäßigerweise eine Amplitudenhöhe von maximal 2 $\mu$m.

## Patentansprüche

1. Betätigungselement mit einem Körper (2) aus einem Elastomermaterial, der auf zwei einander gegenüberliegenden Begrenzungsflächen (3, 4) mit jeweils einer Elektrodenanordnung (5, 6) versehen ist, wobei mindestens eine Begrenzungsfläche (3, 4) einen durch eine Form mit einem gewellten Oberflächenprofil gebildeten gewellten Bereich mit parallel zur Querrichtung verlaufenden Höhen (13) und Tiefen (14) als Extreme aufweist, der von einer Elektrode (5, 6) bedeckt ist, die zumindest einen Teil der Extreme (13, 14) vollflächig abdeckt und im Übrigen über den gewellten Bereich zusammenhängt.

2. Betätigungselement nach Anspruch 1, **dadurch gekennzeichnet, dass** die Elektrode (5, 6) den gewellten Bereich vollflächig abdeckt.

3. Betätigungselement nach Anspruch 1 oder 2, **dadurch gekennzeichnet, dass** die Elektrode (5, 6) unmittelbar mit dem Körper (2) verbunden ist.

4. Betätigungselement nach einem der Ansprüche 1 bis 3, **dadurch gekennzeichnet, dass** die Extreme (13, 14) Amplituden (a) aufweisen, die nicht größer sind als 20% der Dicke (d) des Körpers (2) zwischen den Begrenzungsflächen (3, 4).

5. Betätigungselement nach Anspruch 4, **dadurch gekennzeichnet, dass** die Elektrode (5, 6) eine Stärke (h) aufweist, die maximal 10% der Amplitude (a) beträgt.

6. Betätigungselement nach Anspruch 4 oder 5, **dadurch gekennzeichnet, dass** das Verhältnis zwischen Amplitude (a) und Periodenlänge (L) im Bereich von 0,08 bis 0,25 liegt.

7. Betätigungselement nach einem der Ansprüche 1 bis 6, **dadurch gekennzeichnet, dass** der gewellte Bereich ein Rechteckprofil aufweist.

8. Betätigungselement nach Anspruch 7, **dadurch gekennzeichnet, dass** das Rechteckprofil Zähne und Zahnlücken aufweist, die in Längsrichtung (12) gleich lang sind.

9. Verfahren zum Herstellen eines Betätigungselement mit einem Körper aus einem Elastomermaterial, der auf zwei einander gegenüberliegenden Seiten jeweils mit einer Elektrode versehen wird, wobei ein Elastomer in einer Form (7) mit einem gewellten Oberflächenprofil (8) zu einem Film (9) gepresst wird, den man so kurz aushärten lässt, dass er noch formbar bleibt, dann eine weitere Form (10) mit der gewellten Oberfläche (11) gegen die andere Seite des Films (9) presst und nach Ausbilden der Oberflächenstruktur eine leitende Schicht auf die Oberfläche aufträgt.

10. Verfahren nach Anspruch 9, **dadurch gekennzeichnet, dass** die leitende Schicht aufgedampft wird.

## Claims

1. Actuating element with a member (2) of an elastomer material, said member being provided on each of two oppositely arranged bordering faces (3, 4) with an electrode arrangement (5, 6), at least one bordering face (3, 4) comprising a corrugated area having elevations (13) and depressions (14) as extremes extending in parallel to the transverse direction and being formed by a mould with a corrugated surface profile, said area being covered by an electrode (5, 6) that covers at least a part of the extreme (13, 14) completely and otherwise is joined across the corrugated area.

2. Actuating element according to claim 1, **characterised in that** the electrode (5, 6) completely covers the corrugated area.

3. Actuating element according to claim 1 or 2, **characterised in that** the electrode (5, 6) is directly connected to the member (2).

4. Actuating element according to one of the claims 1 to 3, **characterised in that** the extreme (13, 14) has amplitudes (a), which are not larger than 20% of the thickness (d) of the member (2) between the bordering faces (3, 4).

5. Actuating element according to claim 4, **characterised in that** the electrode (5, 6) has a thickness (h) that amounts to maximum 10% of the amplitude (a).

6. Actuating element according to claim 4 or 5, **characterised in that** the ratio between the amplitude (a) and a period length (L) is in the range from 0.08 to 0.25.

7. Actuating element according to one of the claims 1 to 6, **characterised in that** the corrugated area has a rectangular profile.

8. Actuating element according to claim 7, **characterised in that** the rectangular profile comprises teeth and tooth spaces, which have the same length in the longitudinal direction (12).

9. Method of manufacturing an actuating element with a member of an elastomer material, said member being provided on each of two oppositely arranged bordering faces with an electrode, an elastomer being pressed in a mould (7) with a corrugated surface profile (8) to a film (9) that is hardened for such a short time that it remains formable, a further mould (10) with the corrugated surface (11) being pressed against the other side of the film (9), a conducting layer being applied to the surface after formation of the surface structure.

10. Method according to claim 9, **characterised in that** the conducting layer is applied by means of steaming.

**Revendications**

1. Elément d'actionnement avec un corps (2) en un matériau élastomère qui est pourvu d'un ensemble d'électrodes (5, 6) respectivement sur deux surfaces de délimitation (3, 4) opposées, dans lequel au moins une surface de délimitation (3, 4) présente une zone ondulée formée par un moule avec un profil de surface ondulé doté comme extrêmes d'élévations (13) et de renfoncements (14) s'étendant parallèlement à la direction transversale, laquelle zone ondulée est recouverte d'une électrode (5, 6) qui recouvre sur toute la surface au moins une partie des extrêmes (13, 14) et qui s'étend par ailleurs sur la zone ondulée.

2. Elément d'actionnement selon la revendication 1, **caractérisé en ce que** l'électrode (5, 6) recouvre toute la surface de la zone ondulée.

3. Elément d'actionnement selon la revendication 1 ou 2, **caractérisé en ce que** l'électrode (5, 6) est directement reliée au corps (2).

4. Elément d'actionnement selon l'une quelconque des revendications 1 à 3, **caractérisé en ce que** les extrêmes (13, 14) présentent des amplitudes (a) qui ne sont pas supérieures à 20 % de l'épaisseur (d) du corps (2) entre les surfaces de délimitation (3, 4).

5. Elément d'actionnement selon la revendication 4, **caractérisé en ce que** l'électrode (5, 6) présente une épaisseur (h) qui s'élève au maximum à 10 % de l'amplitude (a).

6. Elément d'actionnement selon la revendication 4 ou 5, **caractérisé en ce que** le rapport entre l'amplitude (a) et la longueur de période (L) est compris entre 0,08 et 0,25.

7. Elément d'actionnement selon l'une quelconque des revendications 1 à 6, **caractérisé en ce que** la zone ondulée présente un profil rectangulaire.

8. Elément d'actionnement selon la revendication 7, **caractérisé en ce que** le profil rectangulaire présente des dents ou des entredents qui sont de même longueur dans le sens longitudinal (12).

9. Procédé de fabrication d'un élément d'actionnement avec un corps en un matériau élastomère qui est pourvu sur deux côtés opposés respectivement d'une électrode, dans lequel un élastomère est pressé dans un moule (7) avec un profil de surface (8) ondulé pour former un film (9) qu'on peut laisser brièvement durcir, de sorte qu'il reste encore façonnable, puis on presse ensuite un autre moule (10) avec la surface ondulée (11) contre l'autre côté du film (9) et on applique, après la réalisation de la structure de la surface, une couche conductrice sur la surface.

10. Procédé selon la revendication 9, **caractérisé en ce que** la couche conductrice est métallisée sous vide.

# Fig.1

# Fig.2

# Fig.3

# Fig.4

**EP 1 330 867 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5977685 A
- WO 0106579 A2

- JP 01273372 A